# EUROPÄISCHE PATENTSCHRIFT

(11) **EP 2 355 645 B1**
(45) Veröffentlichungstag und Bekanntmachung des Hinweises auf die Patenterteilung: **13.06.2012**
(21) Anmeldenummer: 10001244.2
(22) Anmeldetag: 06.02.2010
(51) Int. Cl.: H05K 13/04

(54) **Montageeinrichtung zum Aufbringen eines RFID-Chipmoduls auf ein Substrat, insbesondere eine Etikette**
Fitting device for attaching an RFID chip module to a substrate, in particular a label
Dispositif de montage destiné à l'application d'un module de puce RFID sur un substrat, notamment une étiquette

(43) Veröffentlichungstag der Anmeldung: 10.08.2011
(73) Patentinhaber: TEXTILMA AG, 6362 Stansstad (CH)
(72) Erfinder: Bühler, Stephan, 8114 Dänikon (CH)
(74) Vertreter: Schmauder & Partner AG Patent- & Markenanwälte VSP

(56) Entgegenhaltungen:
- WO-A1-2006/058324
- US-A1- 2003 136 503
- US-A1- 2004 192 011
- US-A1- 2006 026 819

## Beschreibung

### Gegenstand der Erfindung

Die Erfindung betrifft eine Montageeinrichtung zum Aufbringen eines RFID-Chipmoduls auf ein Substrat, insbesondere eine Etikette.

### Hintergrund der Erfindung und Stand der Technik

Um Substrate mit zumindest einem Leiter, insbesondere Etiketten mit RFID-Transponderchips auszustatten, hat es sich - wie in der WO 2009/003299 A1 gezeigt - als vorteilhaft herausgestellt, solche RFID-Transponderchips zunächst einmal auf RFID-Chipmodule zu platzieren, deren Anschlüsse mit einem Lötmittel versehen sind. Diese RFID-Chipmodule gilt es dann vorteilhaft auf einen Streifen von vorgefertigten Substraten, wie Etiketten, insbesondere Textiletiketten anzubringen. Solche Leiter sind an den Substraten zum Beispiel aufgedruckt, eingewebt, eingenäht oder dergleichen. Solche Leiter sind beispielsweise Antennenleiter für die RFID-Chipmodule. Die RFID-Chipmodule werden an der Stelle, an der das Lötmittel angeordnet ist, mit dem Leiter durch Schmelzen des Lötmittels verbunden. Diese Montage erscheint aber kompliziert und aufwändig.

US 2003/ 136503 A1 offenbart ein Verfahren zum kontinuierlichen Zusammenfügen von RFID-Chipmodulen und Antennen, mittels einer Stanzvorrichtung zum Ausstanzen der RFID-Chipmodule aus einem Trägerband. Die Stanzvorrichtung der US 2003/ 136503 A1 soll eine Stanzmatrix mit einer stanzöffnung zur positionsgenauen Aufnahme eines auszustanzenden RFID-Chipmoduls sowie einen über der Stanzöffnung angeordneten Stanzstempel aufweisen. Unter der Stanzöffnung soll ein Auflager für die positionsgenaue Aufnahme eines Substrats angeordnet sein. Dabei ist eine Saugvorrichtung zum Halten des RFID-Chipmoduls vorgesehen. Weiterhin ist in der US 2003/ 136503 A1 vorgesehen, die RFID-Chipmodule mit Hilfe eines Klebers an den Antennenkontakten zu befestigen, wobei die Antennen als Muster auf dem Substrat ausgebildet sein sollen.

US 2004/192011 A1 offenbart eine Montageeinheit mit einer Vorrichtung zum Positionieren und Aufbringen von RFID-Chips, welche auf einem Wafer in einem vorhergehenden Vorgang geschnitten wurden, mittels eines Pins auf entsprechende Leitermodule, Dabei sind die Leitermodule oberhalb einer Zeile von RFID-Chips so ausgerichtet, dass jeweils ein RFID-Chip aus der Zeile auf einem der Leitermodule aufbringbar ist. Die Vorrichtung weist Führungslöcher zur genauen Positionierung der RFID-Chips auf. Weiterhin ist eine Laserhetzvorrichtung zum Herstellen einer leitenden Verbindung jeweils eines elektrischen Anschlusses des RFID-Chips und dem Leitermodul vorgesehen.

### Darstellung der Erfindung

Es ist somit die Aufgabe der Erfindung, eine Montageeinrichtung zur Verfügung zu stellen, mit der der oben genannte Montagevorgang vereinfacht und auch im Hinblick auf die Präzision verbessert werden kann.

Die Erfindung löst die oben genannte Aufgabe durch eine Montageeinrichtung gemäss Anspruch 1. Dabei haben die Massnahmen der Erfindung zunächst einmal zur Folge, dass einerseits eine Vereinfachung durch die verschiedenen Funktionen der erfindungsgemässen Montageeinrichtung möglich ist, dass aber andererseits auch eine höhere Genauigkeit des Herstellungsablaufes erreicht wird.

Besonders vorteilhaft ist die erfindungsgemässe Montageeinrichtung, wenn die Saugeinrichtung eine an der Stanzseite des Stanzstempels angeordnete Saugöff-nung aufweist. Die Saugöffnung ist zum Beaufschlagen mit Unterdruck mittels einer Saugleitung mit der Saugeinrichtung, vorzugsweise einer Saugpumpe verbunden.

Weiterhin sehr vorteilhaft ist es, wenn die Heizeinrichtung an der Stanzseite des Stanzstempels ausgebildete Hotspots umfasst. Die Hotspots können beispielsweise durch Öffnungen auf der Stanzseite des Stanzstempels gebildet sein, durch die ein Laserstahl auf das RFID-Chipmodul an dessen mit Lötmittel versehenen Stellen auftrifft. Die Hotspots können als Thermoden ausgebildet sein, welche vorteilhafterweise durch im Stanzstempel ausgebildete Führungskanäle der Lötstelle zuführbar und rückführbar sind und welche mittels Laser oder Heizpatronen mit Wärme versorgt werden.

Die vorbenannten sowie die beanspruchten und in den nachfolgenden Ausführungsbeispielen beschriebenen, erfindungsgemäss zu verwendenden Elemente unterliegen in ihrer Grösse, Formgestaltung, Materialverwendung und ihrer technischen Konzeption keinen besonderen Ausnahmebedingungen, so dass die in dem jeweiligen Anwendungsgebiet bekannten Auswahlkriterien uneingeschränkt Anwendung finden können.

### Kurze Beschreibung der Figuren

Ausführungsbeispiele der Erfindung werden nachfolgend anhand von Zeichnungen näher beschrieben, dabei zeigen:
- Figur 1: Eine Montageeinrichtung zum Aufbringen eines RFID-Chipmoduls auf ein Etikett, in schaubildlicher Darstellung;
- Figur 2: Die Montageeinrichtung der Figur 1 in Ausgangsposition, im Vertikal- schnitt;
- Figur 3: Die Montageeinrichtung der Figur 2, beim Setzen und Löten des RFID- Chipmoduls;
- Figur 4: Den Stanzstempel der Montageeinrichtung im Detail.

### Wege zur Ausführung der Erfindung

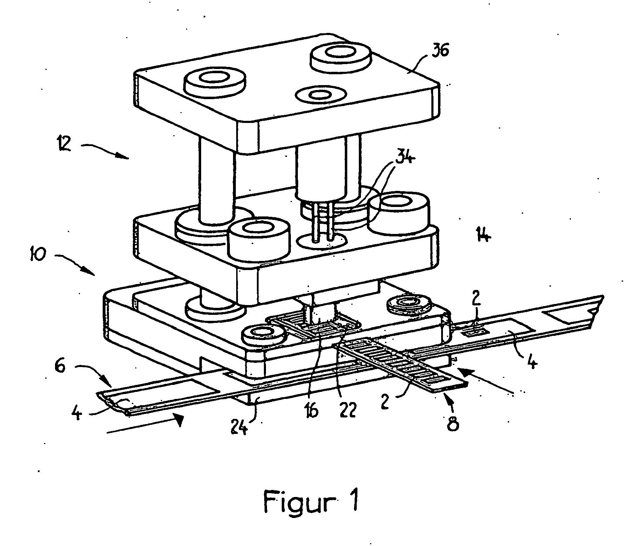

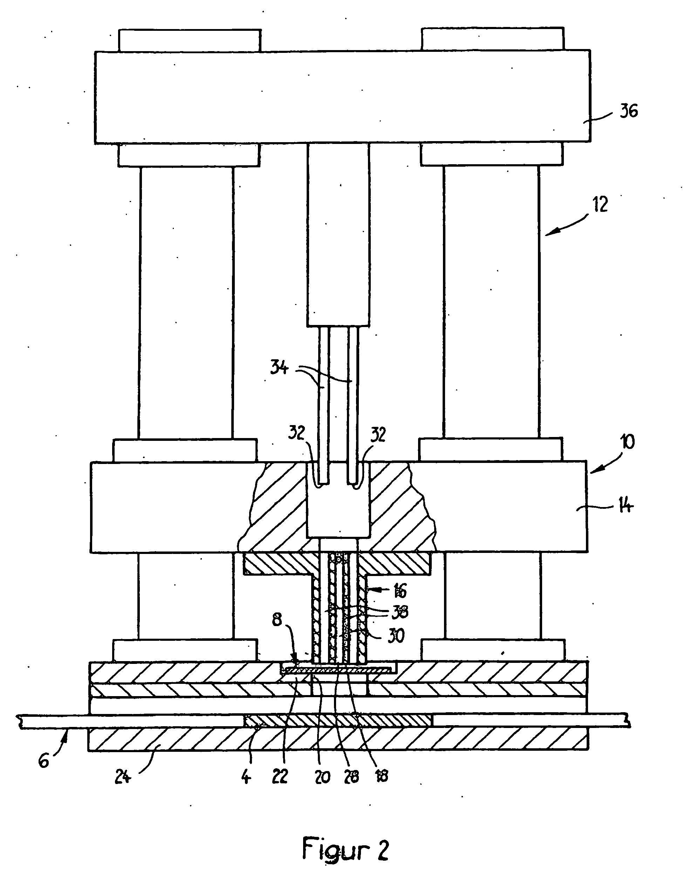

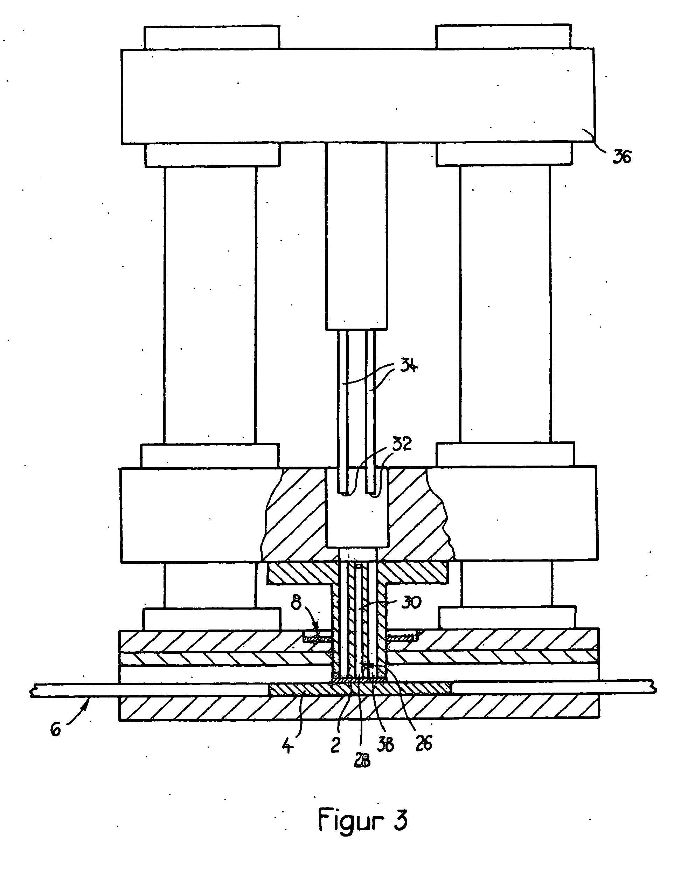

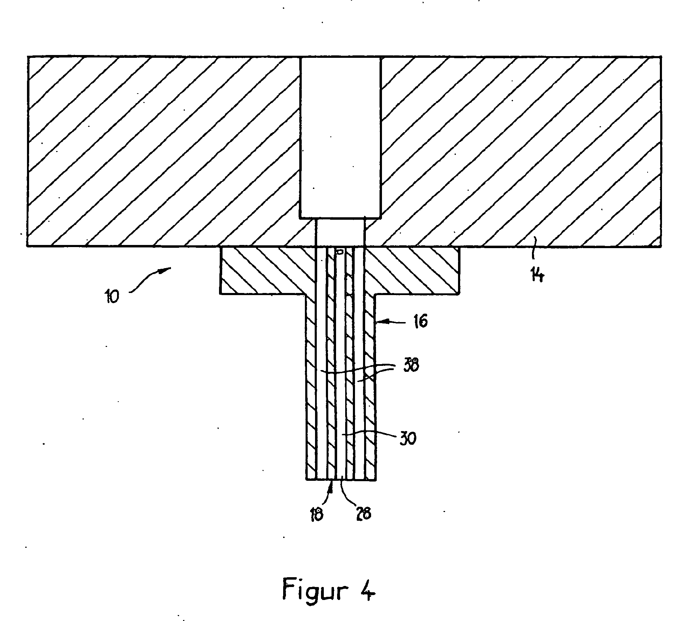

Die Figuren 1 bis 4 zeigen eine Einrichtung zur Montage eines RFID-Chipmoduls 2 an einem Substrat 4 in Form einer Etikette, wobei das Substrat 4 in Form eines Substratbandes 6 und die RFID-Chipmodule 2 in Form eines Trägerbandes 8 einer Stanzvorrichtung 10 zugeführt werden. Letztere stanzt jeweils ein RFID-Chipmodul 2 aus dem Trägerband 8 aus und führt dies unmittelbar einem darunter liegenden Substrat 4 zu. Die Stanzvorrichtung 10 ist mit einer Heizvorrichtung 12 kombinierte, welche das bereits mit Lötmittel versehene RFID-Chipmodul 2 mit am Substrat 4 angeordneten Leitern, insbesondere Antennenleitern, durch Aufschmelzen des Lötmittels verbindet. Das am RFID-Chipmodul 2 vorhandene Lötmittel sowie der am Substrat 4 angeordnete Leiter, insbesondere Antennenleiter sind nicht dargestellt.

Die Stanzvorrichtung 10 weist einen an einer verfahrbaren Tragplatte 14 angeordneten Stanzstempel 16 auf, dessen Stanzseite 18 einer Stanzöffnung 20 einer Stanzmatrix 22 gegenübersteht. Das Trägerband 8 liegt auf der Stanzmatrix 22 auf und wird so zugeführt, dass das auszustanzende RFID-Chipmodul 2 positionsgenau an der Stanzöffnung 20 liegt. Eine nicht näher dargestellte Antriebsvorrichtung bewegt den Stanzstempel 16 unter Ausstanzen des RFID Chipmoduls durch die Stanzöffnung 20 bis gegen das auf einem Auflager 24 unterhalb der Stanzöffnung 20 positionsgenau angeordnete Substrat 4. Die positionsgenaue Zuführung des Trägerbandes 8 mit den RFID-Chipmodulen 2 sowie des Substratbandes 6 mit den Substraten 4 kann grundsätzlich von Hand erfolgen, zweckmässigerweise sind jedoch nicht näher dargestellte Führungen und Zuführvorrichtungen vorhanden, die durch Steuermittel entsprechend der Ausgestaltung der Substrate und der RFID-Chipmodule gesteuert werden.

Um ein unkontrolliertes Herunterfallen des ausgestanzten RFID-Chipmoduls zu verhindern, ist die Stanzvorrichtung 10 mit einer Saugvorrichtung 26 ausgestattet, welche den RFID-Chipmodul 2 vom Ausstanzen bis zum Befestigen am Substrat 4 an der Stanzseite 18 festhält. Im vorliegenden Ausführungsbeispiel ist hierzu mindestens eine an der Stanzseite angeordnete Saugöffnung 28 vorhanden, die über einen Saugkanal 30 in dem Stanzstempel 16 in nicht weiter dargestellter Weise mit einer Unterdruckvorrichtung verbunden ist. Der Unterdruck an der Saugöffnung wird beim Ausstanzen des RFID-Chipmoduls angelegt und nach dessen Verbinden mit dem Substrat wieder ausgeschaltet.

Die mit der Stanzvorrichtung 10 kombinierte Heizvorrichtung 12 weißt den Lötstellen zugeordnete Hotspots 32 an der Stanzseite 18 des Stanzstempels 16 auf, wobei die Wärmezufuhr über verschiedene Verfahren und Mittel (Laser, Heizpatronen etc.) erfolgen kann. Im vorliegenden Beispiel werden die Hotspots 32 vorzugsweise durch Heizelemente (Thermoden) 34 gebildet, welche an einem mittels nicht näher dargestellter Antriebsmittel verfahrbaren Träger 36 angeordnet sind. Die Heizelemente 34 werden nach dem Ausstanzen des RFID-Chipmoduls 2 und dessen Ablegen auf dem Substrat 4 durch Führungskanäle 38 im Stanzstempel 16 am RFID-Chipmodul 2 zur Anlage gebracht, um das Lötmittel am RFID-Chipmodul aufzuschmelzen und dessen Anschlüsse mit den Leiterfäden des Substrates 4 zu verbinden. Nach dem Aufschmelzen des Lötmittels werden die Heizelement 34 zurückgezogen und der Stanzstempel 16 bleibt bis zum Erstarren des Lötmittels am RFID-Chipmodul 2, um dessen Ablösen zu verhindern. Danach fährt der Stanzstempel 16 wieder in seine Ausgangsposition. Besonders vorteilhaft ist es, wenn die Heizvorrichtung eine Lasereinrichtung aufweist, welche jeweils einen Laserstrahl durch die Führungskanäle auf die entsprechende Lötstelle des RFID-Chipmoduls sendet. Die Lasereinrichtung ermöglicht eine verbesserte Steuerung des Lötvorganges in thermischer und zeitlicher Hinsicht.

Das Substrat kann beispielsweise ein Streifen aus Papier, Kunststoff oder Textilmaterial sein. Der Leiter kann durch Drucken, Nähen oder insbesondere durch Einweben oder Einwirken mit dem entsprechenden Substrat verbunden sein. Das Substrat ist insbesondere ein Etikett.

### Bezugszeichenliste

- 2: RFID Chipmodul
- 4: Substrat
- 6: Substratband
- 8: Trägerband
- 10: Stanzvorrichtung
- 12: Heizvorrichtung
- 14: Tragplatte
- 16: Stanzstempel
- 18: Stanzseite
- 20: Stanzöffnung
- 22: Stanzmatrix
- 24: Auflage
- 26: Saugvorrichtung
- 28: Saugöffnung
- 30: Saugkanal
- 32: Hotspot
- 34: Heizelement
- 36: Träger
- 38: Führungskanal

## Patentansprüche

1. Montageeinrichtung zum Aufbringen eines RFID-Chipmoduls (2) mit zumindest einem elektrischen Anschluss auf ein Substrat (4) mit zumindest einem Leiter, insbesondere eine Etikette,
enthaltend :
- eine Stanzvorrichtung (10) zum Ausstanzen des RFID-Chipmoduls (2) aus einem Trägerband (8) mit einer Vielzahl von Chipmodulen (2), wobei die Stanzvorrichtung eine Stanzmatrix (22) mit einer Stanzöffnung (20) zur positionsgenauen Aufnahme eines auszustanzenden RFID-Chipmoduls (2) sowie einen über der Stanzöffnung (20) angeordneten Stanzstempel (16) aufweist, wobei unter der Stanzöffnung (20) ein Auflager (24) für die positionsgenaue Aufnahme eines Substrates (4) angeordnet ist und der Stanzstempel (16) bis gegen das Substrat (4) verfahrbar ist;
- eine Saugvorrichtung (26) zum Halten des RFID-Chipmoduls (2) am Stanzstempel (16) sowie;
- eine Heizvorrichtung (12) zum Aufschmelzen von an dem RFID-Chipmodul (2) vorhandenen Lötmitteln zum Herstellen einer leitenden Verbindung jeweils eines elektrischen Anschlusses des RFID-Chipmoduls (2) jeweils mit einem Leiter des Substrats (4).

2. Montageeinrichtung nach Anspruch 1, **dadurch gekennzeichnet, dass** die Saugvorrichtung (26) Ansaugmittel zum Ausbilden eines Unterdruckes zumindest an einem Punkt der Stanzseite (18) des Stanzstempels (16) aufweist.

3. Montageeinrichtung nach Anspruch 2, **dadurch gekennzeichnet, dass** die Ansaugmittel eine an der Stanzseite (18) des Stanzstempels (16) angeordnete Saugöffnung (28) zum Anlegen des Unterdrucks aufweisen.

4. Montageeinrichtung nach Anspruch 3, **dadurch gekennzeichnet, dass** die Saugöffnung (28) mittels eines durch den Stanzstempel verlaufende Saugkanals (30) mit einer Unterdruckversorgung verbunden ist.

5. Montageeinrichtung nach einem der Ansprüche 1 bis 4, **dadurch gekennzeichnet, dass** die Heizvorrichtung (12) Thermoden (34) umfassen, die durch im Stanzstempel ausgebildete Führungskanäle (38) der Lötstelle zuführbar und rückführbar sind.

6. Montageeinrichtung nach Anspruch 5, **dadurch gekennzeichnet, dass** die Thermoden (34) mittels einer Laserstrahlquelle oder einer Heizpatrone mit Wärme versorgbar sind.

7. Montageeinrichtung nach einem der Ansprüche 1 bis 4, **dadurch gekennzeichnet, dass** die Heizvorrichtung (12) eine Lasereinrichtung aufweist, welche jeweils eine auf die zu lötende Stelle des RFID-Chipmoduls gerichtete Laserstrahlenquelle aufweist.

## Claims

1. A mounting device for attaching an RFID chip module (2) with at least one electrical connection to a substrate (4) with at least one conductor, particularly onto a label,
**characterized by**:
- a punching device (10) for punching out the RFID chip module (2) from a carrier tape (8) with a plurality of chip modules (2), wherein the punching device comprises a punching matrix (22) with a punching aperture (20) for positionally accurately receiving an RFID chip module (2) to be punched out and a punching die (16) arranged above the punching aperture (20),
wherein under the punching opening (20) there is disposed a support (24) for positionally accurately receiving a substrate (4) and wherein the punching die (16) is displaceable towards and against the substrate (4);
- a suction device (26) for holding the RFID chip module (2) to the punching die (16) and;
- a heating device (12) for melting any soldering means present on the RFID chip module (2) for producing a conductive connection between each of an electrical connection of the RFID chip module (2) and a respective conductor of the substrate (4).

2. The mounting device according to claim 1, **characterized in that** the suction device (26) comprises suction means for forming an underpressure at least at one point of the punching side (18) of the punching die (16).

3. The mounting device according to claim 2, **characterized in that** the suction means comprise a punching aperture (28) arranged at the punching side (18) of the punching die (16) for applying the underpressure.

4. The mounting device according to claim 3, **characterized in that** the punching aperture (28) is connected with an underpressure supply by means of a suction channel (30) extending through the punching die.

5. The mounting device according to any one of claims 1 to 4, **characterized in that** the heating device (12) comprises thermodes (34) configured to be fed in and retracted through the guide channels (38) formed in the punching die.

6. The mounting device according to claim 5, **characterized in that** the thermodes (34) are supplied with heat by means of a laser beam source or a heating cartridge.

7. The mounting device according to any one of claims 1 to 4, **characterized in that** the heating device (12) comprises a laser device which comprises, respectively, a laser beam source directed onto the location of the RFID chip module to be soldered.

## Revendications

1. Dispositif de montage pour l'application d'un module de puce RFID (2) comportant au moins une borne de liaison électrique sur un substrat (4) comportant au moins un conducteur, en particulier une étiquette, comprenant :
- un dispositif de poinçonnage (10) pour poinçonner le module de puce RFID (2) à partir d'une bande support (8) ayant une série de modules de puce (2), le dispositif de poinçonnage comportant une matrice de poinçonnage (22) avec une ouverture de poinçonnage (20) pour permettre la réception dans une position précise d'un module de puce RFID (2) à poinçonner, ainsi qu'un poinçon (16) monté au dessus de l'ouverture de poinçonnage (20), un support d'appui (24) étant monté au dessous de l'ouverture de poinçonnage pour permettre la réception d'un substrat (4) dans une position précise et le poinçon (16) pouvant être déplacé jusqu'à venir contre le substrat (4),
- un dispositif d'aspiration (26) maintenir le module de puce RFID (2) sur le poinçon (16), et
- un dispositif de chauffage (12) pour faire fondre un agent de brasage situé sur le module de puce RFID (2) de façon à obtenir une liaison conductrice d'une borne électrique respective du module de puce RFID (2) avec un conducteur respectif du substrat (4).

2. Dispositif de montage conforme à la revendication 1,
**caractérisé en ce que**
le dispositif d'aspiration (26) comporte des moyens d'aspiration pour former une dépression au moins en un point de la face de poinçonnage (18) du poinçon (16).

3. Dispositif de montage conforme à la revendication 2,
**caractérisé en ce que**
les moyens d'aspiration comportent une ouverture d'aspiration (28) située sur la face de poinçonnage (18) du poinçon (16) pour établir la dépression.

4. Dispositif de montage conforme à la revendication 3,
**caractérisé en ce que**
l'ouverture d'aspiration (28) est reliée à une source de dépression par un canal d'aspiration (30) s'étendant au travers du poinçon.

5. Dispositif de montage conforme à l'une des revendications 1 à 4,
**caractérisé en ce que**
le dispositif de chauffage (12) comporte des barres de soudure ou thermodes (34) qui peuvent être déplacées vers le point de brasage ou dégagées de celui-ci au travers de canaux de guidage (38) réalisés dans le poinçon.

6. Dispositif de montage conforme à la revendication 5,
**caractérisé en ce que**
les thermodes (34) sont alimentées en chaleur au moyen d'une source de rayonnement laser ou d'une cartouche chauffante.

7. Dispositif de montage conforme à l'une des revendications 1 à 4,
**caractérisé en ce que**
le dispositif de chauffage (12) comporte un dispositif laser respectivement équipé d'une source de rayonnement laser dirigée sur le point à braser du module de puce RFID.
